# EUROPÄISCHE PATENTSCHRIFT

(11) **EP 2 671 431 B1**
(45) Veröffentlichungstag und Bekanntmachung des Hinweises auf die Patenterteilung: **12.07.2017**
(21) Anmeldenummer: 11790988.7
(22) Anmeldetag: 06.12.2011
(51) Int. Cl.: H05K 1/14, H05K 1/18, H05K 1/02, H05K 3/32

(54) **LEITERPLATTENANORDNUNG**
CIRCUIT BOARD ARRANGEMENT
ENSEMBLE CARTE DE CIRCUIT IMPRIMÉ

(30) Priorität: 31.01.2011 DE 102011003377
(43) Veröffentlichungstag der Anmeldung: 11.12.2013
(73) Patentinhaber: ZF Friedrichshafen AG, 88046 Friedrichshafen (DE)
(72) Erfinder: MAIER, Thomas, 92431 Neunburg v. Wald (DE)
(86) Internationale Anmeldenummer: PCT/EP2011/071841
(87) Internationale Veröffentlichungsnummer: WO 2012/103969

(56) Entgegenhaltungen:
- WO-A1-03/028415
- WO-A1-2008/058782
- DE-A1- 19 720 167
- FR-A1- 2 426 984
- GB-A- 2 403 603
- US-A1- 2003 107 874

## Beschreibung

Die vorliegende Erfindung betrifft eine Leiterplattenanordnung gemäß dem Oberbegriff von Anspruch 1, insbesondere für ein Kraftfahrzeug-Steuergerät.

Zur Bildung eines Kraftfahrzeug-Steuergeräts, insbesondere einer mechatronischen Getriebesteuerung, ist es wünschenswert, Leitungsträgerstrukturen des Steuergeräts möglichst flexibel bzw. unter Ausgleich von Toleranzen sowohl an PeripherieKomponenten des Steuergeräts als auch an der Steuerelektronik anbinden zu können und dennoch einen robusten Aufbau des Steuergeräts sicherzustellen. Zudem soll ein Steuergerät günstig und kompakt sein. Druckschrift DE 197 20 167 A1 offenbart den Oberbegriff des Anspruchs 1.

Die Druckschrift DE 199 55 603 C1 zeigt ein Getriebesteuergerät, bei welchem die Steuerelektronik auf einem Keramiksubstrat aufgenommen ist und wobei zur Bildung einer robusten Anordnung Leiterstränge zur Vernetzung der Steuerelektronik von Kunststoffmaterial eines Leitungsträgers umspritzt sind. Der derart gebildete Leitungsträger ist zur Verbindung mit peripheren Komponenten begrenzt beweglich. Diese Anordnung ist jedoch aufwändig in der Herstellung und somit teuer. Zudem baut das Steuergerät groß.

Im Stand der Technik ist aus der Druckschrift DE 10 2004 019 431 A1 weiterhin eine Anordnung bekannt, bei welcher eine Schaltungsträgerplatte, welche insbesondere mittels keramischem Trägermaterial gebildet ist, in einer Aussparung einer starren Leiterplatte angeordnet ist. Hierdurch ergibt sich ein flacher Aufbau einer damit bildbaren Schaltungsanordnung. Diese Lösung ist jedoch aufwändig in ihrer Herstellung, insofern als enge Toleranzen bei der Herstellung der Anordnung einzuhalten sind. Des Weiteren wird ein teurer Schaltungsträger eingesetzt, um hochintegriert klein zu bauen. Die Nutzung von starrem Leiterplattenmaterial verhindert letztlich eine flexible bzw. toleranzausgleichende Verbindungsmöglichkeit mit peripheren Komponenten.

Aus der Druckschrift DE 10 2006 040 733 A1 ist weiterhin eine Anordnung bekannt, bei welcher zwei starre Leiterplatten parallel zueinander aneinander angeordnet sind, wobei sich Bauelemente der zweiten Leiterplatte in eine Aussparung in der ersten Leiterplatte hinein erstrecken, derart, dass diese EMV-geschirmt sind. Auch diese Anordnung ermöglicht einen flachen Aufbau, jedoch keine Toleranzausgleichsmöglichkeit.

Die bekannten Anordnungen sind hiernach zur Bildung eines robusten und klein bauenden Steuergeräts eines Kraftfahrzeugs insoweit nachteilig, als entweder ein auch finanziell hoher Aufwand zu betreiben ist oder lediglich ein niedriger Integrationsgrad einer Elektronik erzielt wird. Ein Toleranzausgleich bei Anbindung peripherer Komponenten ist gar nicht oder nur begrenzt möglich.

Es ist daher Aufgabe der vorliegenden Erfindung, eine Leiterplattenanordnung vorzuschlagen, welche die Nachteile des Standes der Technik überwindet, und die einfache und kostengünstige Herstellung eines hinsichtlich seiner Elektronik hochintegrierten und äußerst kompakt bauenden Steuergeräts insbesondere mit Toleranzausgleichsmöglichkeit ermöglicht.

Die Aufgabe wird erfindungsgemäß durch die Merkmale von Anspruch 1 gelöst.

Vorgeschlagen wird erfindungsgemäß weiterhin eine Leiterplattenanordnung, wobei die Standard-Leiterplatte mittels eines steifen Trägermaterials gebildet ist, insbesondere mittels eines epoxidharzbasierten Trägermaterials, und weiterhin insbesondere flexibel.

Bei einer Ausführungsform der erfindungsgemäßen Leiterplattenanordnung überlappt die HDI-Leiterplatte die Aussparung vollständig, deckelt diese insbesondere.

Bei einer weiteren Ausführungsform der erfindungsgemäßen Leiterplattenanordnung ist die HDI-Leiterplatte an einem Randbereich derselben an die Standard-Leiterplatte ankontaktiert, insbesondere einen Oberflächenbereich der Standard-Leiterplatte benachbart zur Aussparung kontaktierend.

Gemäß einem weiteren Aspekt der erfindungsgemäßen Leiterplattenanordnung ist die HDI-Leiterplatte mittels der mechanischen Verbindung elektrisch an der Standard-Leiterplatte ankontaktiert, insbesondere mittels eines Klebstoffs.

Gemäß noch einem Aspekt der erfindungsgemäßen Leiterplattenanordnung sind die HDI-Leiterplatte und die Standard-Leiterplatte untereinander mechanisch unverbunden.

Vorgeschlagen wird erfindungsgemäß weiterhin eine Leiterplattenanordnung, wobei die HDI-Leiterplatte beidseitig bestückt ist.

Vorgeschlagen wird erfindungsgemäß auch ein Steuergerät, insbesondere für ein Kraftfahrzeug, mit einer erfindungsgemäßen Leiterplattenanordnung.

Vorgeschlagen wird erfindungsgemäß weiterhin ein Steuergerät, wobei mittels der Standard-Leiterplatte eine Peripheriekomponente mit einer Steuerelektronik des Steuergeräts vernetzt ist.

Vorgeschlagen wird erfindungsgemäß auch ein Steuergerät, wobei die Steuerelektronik des Steuergeräts an der HDI-Leiterplatte gebildet ist.

Weitere Merkmale und Vorteile der Erfindung ergeben sich aus der nachfolgenden Beschreibung von Ausführungsbeispielen der Erfindung, anhand der Figuren der Zeichnungen, die erfindungswesentliche Einzelheiten zeigen, und aus den Ansprüchen. Die einzelnen Merkmale können je einzeln für sich oder zu mehreren in beliebiger Kombination bei einer Variante der Erfindung verwirklicht sein.

Beispielhafte Ausführungsformen der Erfindung werden nachfolgend anhand der beigefügten Zeichnungen näher erläutert. Es zeigen:
- Fig. 1 bis 2: Beispiele einer Leiterplattenanordnung
- Fig. 3: exemplarisch jeweils eine Leiterplattenanordnung gemäß einer möglichen Ausführungsform der Erfindung;
- Fig. 4a: exemplarisch eine Standard-Leiterplatte gemäß einer möglichen Ausführungsform der Erfindung; und
- Fig. 4b: exemplarisch eine HDI-Leiterplatte gemäß einer möglichen Ausführungsform der Erfindung zur Verwendung an der Standard-Leiterplatte gemäß Fig. 4a.

In den nachfolgenden Figurenbeschreibungen sind gleiche Elemente bzw. Funktionen mit gleichen Bezugszeichen versehen.

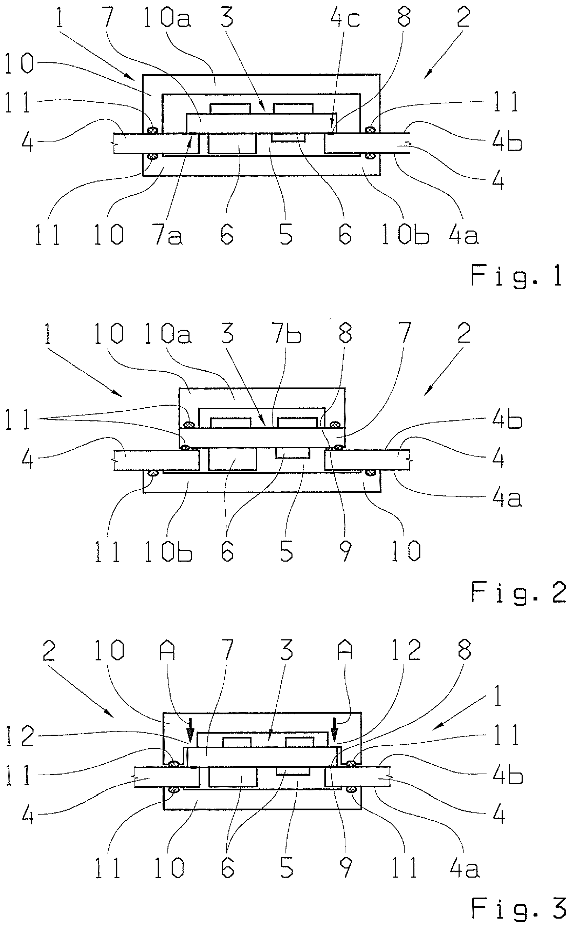

Die Fig. 3 zeigt eine erfindungsgemäße Leiterplattenanordnung 1 für ein Steuergerät 2 eines Kraftfahrzeugs, insbesondere einer Getriebesteuerung eines Kraftfahrzeugs. Ein solches Steuergerät 2, welches mittels einer elektronischen Steuerschaltung 3 gebildet ist, wird z.B. im Ölsumpf eines Getriebes, z.B. eines Automatgetriebes, angeordnet. Das Steuergerät 2 ist z.B. Bestandteil einer mechatronischen Getriebesteuerung.

Die erfindungsgemäße Leiterplattenanordnung 1 weist eine herkömmlich gebildete Leiterplatte bzw. Standard-Leiterplatte 4 auf, welche erfindungsgemäß dazu vorgesehen ist, die elektronische Steuerschaltung 3 bei Bildung eines Steuergeräts 2 für ein Kraftfahrzeug mit einer Peripheriekomponente des Steuergeräts 2, wie z.B. Aktuatoren, Leistungsbaugruppen, Sensoren, etc. zu vernetzen. Hierbei ist die Standard-Leiterplatte 4 z.B. als bloßer Leitungsträger vorgesehen oder alternativ z.B. auch mit elektronischen Bauelementen bestückt. Die Standard-Leiterplatte 4 kann z.B. auch eine Schaltung ausbilden.

Die erfindungsgemäße Standard-Leiterplatte 4 ist insbesondere eine Leiterplatte aus einem steifen bzw. starren Trägermaterial, vorzugsweise aus einem glasfaserverstärkten Epoxidharzmaterial, insbesondere eine FR4-Leiterplatte. Die Standard-Leiterplatte 4 kann hierbei ein- oder mehrlagig gebildet sein, vorzugsweise mehrlagig, wobei sie auf an sich bekannte Weise Leiterbahnen, Leiterflächen, Durchkontaktierungen etc. aufweist bzw. trägt.

Um eine Toleranzausgleichsmöglichkeit zu gewähren, ist die Standard-Leiterplatte 4 erfindungsgemäß insbesondere flexibel bzw. biegbar ausgebildet, insbesondere durch Krafteinwirkung quer zur Erstreckungsebene biegbar. Dies wird vorzugsweise durch eine geeignete Stärke der Standard-Leiterplatte 4 gewährleistet, z.B. eine dünne bzw. sehr dünne Ausbildung der Standard-Leiterplatte 4, welche zerstörungsfrei eine flexible Biegung derselben in einem gewünschten bzw. notwendigen Umfang ermöglicht.

Durch die insbesondere flexible Ausbildung kann die Standard-Leiterplatte 4 als robuster Leiterträger fungieren, insbesondere ausschließlich, und gleichzeitig Toleranzen bei der Anbindung peripherer Komponenten ausgleichen. Eine Kapselung der Standard-Leiterplatte 4 zum Schutz vor aggressiven Medien bei Bildung eines Steuergeräts 2 ist hierbei vorteilhaft nicht notwendig. Durch Verwendung der Standard-Leiterplatte 4 können die Materialkosten bei Bildung eines Steuergeräts 2 zudem niedrig gehalten werden.

Die Standard-Leiterplatte 4 weist erfindungsgemäß eine Ausnehmung bzw. Aussparung 5 auf, welche sich vorzugsweise quer bzw. senkrecht zur Erstreckungsebene der Standard-Leiterplatte 4 erstreckt. Die Aussparung 5 ist hierbei insbesondere in Form einer Durchgangsöffnung gebildet, welche sich von einer großflächigen Leiterplattenseite 4a zur gegenüberliegenden Seite 4b erstreckt, i.e. durch die Standard-Leiterplatte 4 hindurch. Die Aussparung 5 ist z.B. mittels eines spanenden Verfahrensschritts, z.B. durch Fräsen, oder mittels eines nicht spanenden Verfahrensschritts, z.B. durch Laserschneiden, im Zuge der Herstellung der Standard-Leiterplatte 4 gefertigt.

Die Aussparung 5 eröffnet erfindungsgemäß einen Raum innerhalb der Standard-Leiterplatte 4, welcher zur Aufnahme von elektronischen Bauelementen 6 der elektronischen Schaltung 3 nutzbar ist und somit zu einer kompakten Ausbildung eines Steuergeräts 2 beitragen kann.

Um eine kompakt bauende und günstige Leiterplattenanordnung 1 für ein Steuergerät 2 zu schaffen, weist die Leiterplattenanordnung 1 erfindungsgemäß ferner eine HDI-Leiterplatte 7 auf. Die HDI-Leiterplatte 7 (HDI: High Density Interconnect) ist hierbei eine hochintegrationsfähige Leiterplatte, insbesondere eine epoxidharzbasierte Leiterplatte, vorzugsweise eine FR4-Leiterplatte, welche gegenüber der vorstehend beschriebenen Standard-Leiterplatte 4 feinere und insbesondere komplexere Strukturen aufweist. Die erfindungsgemäße HDI-Leiterplatte 7 erfüllt zudem die Anforderungen an die Temperaturverträglichkeit bei Bildung eines Steuergeräts 2.

Die HDI-Leiterplatte 7 nimmt zumindest Teile der elektronischen Bauelemente 6 zur Bildung einer elektronischen Schaltung bzw. der Steuerschaltung 3 für das Kraftfahrzeug-Steuergerät 2 auf, insbesondere die gesamte Steuerschaltung 3. Dabei ist die HDI-Leiterplatte 7 zur Vernetzung der Bauelemente 6 untereinander sowie mit externen Strukturen, welche z.B. an der Standard-Leiterplatte 4 gebildet sind, geeignet mit Leiterstrukturen versehen. Mittels der erfindungsgemäß verwendeten HDI-Leiterplatte 7 kann kostengünstig eine besonders klein bauende und hochintegrierte Steuerschaltung 3 realisiert werden.

Erfindungsgemäß wird die HDI-Leiterplatte 7 vorteilhaft die Aussparung 5 überlappend an der Standard-Leiterplatte 4 angeordnet. Hierbei sind die Standard-Leiterplatte 4 und die HDI-Leiterplatte 7 mit im Wesentlichen parallel ausgerichteten jeweiligen Erstreckungsebenen zueinander benachbart angeordnet, insbesondere an einander. Erfindungsgemäß ist hierbei vorgesehen, dass die HDI-Leiterplatte 7 die Aussparung 5 vollständig überlappt, insbesondere deckelt, Fig. 1 bis 3, i.e. in einer Richtung senkrecht zur Erstreckungsebene der Standard-Leiterplatte 4.

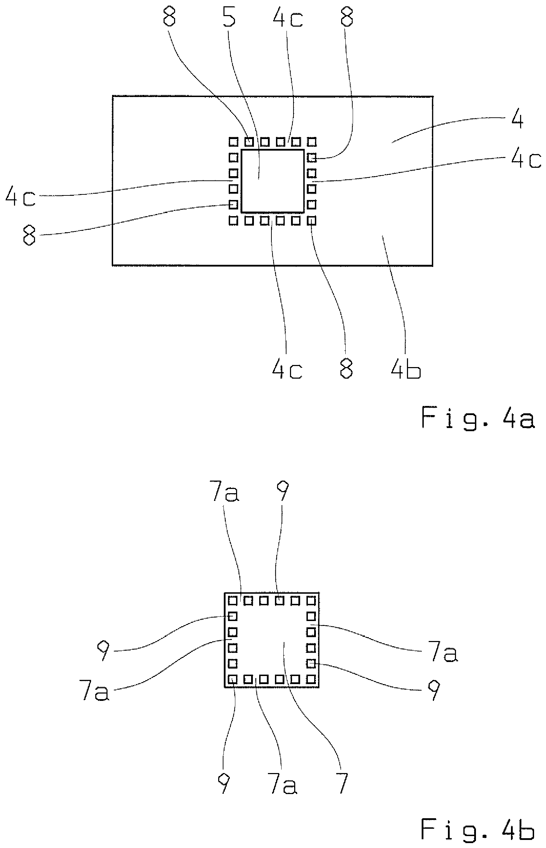

Um die Aussparung 5 zu überlappen und an der Standard-Leiterplatte 4 auf einfache Weise angeordnet, z.B. aufgesetzt, werden zu können, weist die HDI-Leiterplatte 7 Abmessungen in Bezug auf ihre Erstreckungsebene auf, welche zumindest geringfügig größer sind als die der Standard-Leiterplatte 4 in deren Erstreckungsebene, wobei die Querschnitte von HDI-Leiterplatte 7 und Standard-Leiterplatte 4 vorzugsweise korrespondieren. Derart korrespondierende Formen der Aussparung 5 und der HDI-Leiterplatte 7 zeigen z.B. die Fig. 4a und b. Durch eine derart korrespondierende Ausbildung der HDI-Leiterplatte 7 und der Aussparung 5 kann die HDI-Leiterplatte 7 rundumseitig an einem zur Aussparung 5 benachbarten Randbereich der Standard-Leiterplatte 4 zur Anlage gelangen, Fig. 1 bis 3, und dort ankontaktiert werden, wie nachfolgend noch näher erläutert wird.

Durch die die Aussparung 5 überlappende Anordnung der HDI-Leiterplatte 7 an der Standard-Leiterplatte 4 ist es möglich, innerhalb der Abmessungen der Standard-Leiterplatte 4 eine partiell sehr hohe Integrationsdichte der elektronischen Bauelemente 6 bzw. einer Steuerschaltung 3 zu erzielen, insbesondere deshalb, da die hochintegrationsfähige und im Vergleich zu einer Keramik günstige HDI-Leiterplatte 7 nunmehr von zwei Seiten bzw. beidseitig zugänglich und somit bestückbar ist. An der der Standard-Leiterplatte 4 zugewandten Seite der HDI-Leiterplatte 7 angeordnete Bauelemente 6 können in die Aussparung 5 eintauchen, so dass sich darüber hinaus eine sehr flache Leiterplattenanordnung 1 ergibt bzw. realisieren lässt.

Erfindungsgemäß ist - wie vorstehend erwähnt - vorgesehen, die HDI-Leiterplatte 7 an einem Randbereich 7a derselben, i.e. an der der Standard-Leiterplatte 4 zugewandten Seite, an die Standard-Leiterplatte 4 elektrisch anzukontaktieren, wobei die HDI-Leiterplatte 7 insbesondere einen Oberflächenbereich 4c der Standard-Leiterplatte 4 benachbart zur Aussparung 5 kontaktiert. Eine derartige Ankontaktierung, i.e. an Leiterstrukturen der Standard-Leiterplatte 4, erfolgt erfindungsgemäß z.B. mittels am Rand bzw. Umfang der Aussparung 5 angeordneter elektrischer Kontaktelemente 8, welche mit Kontaktelementen 9 der HDI-Leiterplatte 7 korrespondieren, z.B. Fig. 4a und b. Die Kontaktelemente 8, 9 können z.B. als mehrere Flächen bzw. Pads oder auch als durchgehende Umrandung ausgeführt sein. Die Kontaktelemente 8, 9 sind z.B. mittels Leitpaste oder durch Lötkontakte gebildet. Es ist vorgesehen, z.B. Fig. 1 und 2, die HDI-Leiterplatte 7 und die Standard-Leiterplatte 4 neben einer etwaigen mechanischen Verbindung der Kontaktelemente 8, 9 noch zusätzlich mechanisch zu verbinden. Z.B. ist eine mechanische Verbindung mittels Kleben, Verschrauben oder auf andere Weise vorgesehen. Bei einer Variante ist hingegen z.B. vorgesehen, die HDI-Leiterplatte 7, z.B. mittels eines elektrisch leitenden Klebstoffs, mittels der mechanischen Verbindung elektrisch an der Standard-Leiterplatte 4 anzukontaktieren.

Zur Bildung eines Steuergeräts 2 ist vorliegend insbesondere eine Leiterplattenanordnung 1 vorgesehen, bei welcher die Aussparung 5 als auch die elektronischen Bauelemente 6 an der die Aussparung 5 überlappenden HDI-Leiterplatte 7 gekapselt sind. Derart ist die sensible Steuergerätelektronik 3 bzw. deren Bauelemente 6, welche an der HDI-Leiterplatte 7 aufgenommen ist / sind, vor aggressiven Medien, insbesondere eindringendem Öl, geschützt. Die Fig. 1 bis 3 zeigen mögliche Varianten einer Leiterplattenanordnung 1 mit einem Gehäuse 10 zur Kapselung der Bauelemente 6 und der Aussparung 5.

Bei der in Fig. 1 gezeigten Leiterplattenanordnung 1 ist ein erstes 10a und ein zweites 10b Gehäuseelement des Gehäuses 10 zur Kapselung an der Standard-Leiterplatte 4 angeordnet, i.e. jeweils an den großflächigen Leiterplattenseiten 4a, 4b einander gegenüberliegend, wodurch die HDI-Leiterplatte 7 sowie die Bauelemente 6 mitsamt der Aussparung 5 gekapselt sind. Zur Abdichtung ist z.B. jeweils eine Dichtung 11 zwischen je einem Gehäuseelement 10a, 10b und der Standard-Leiterplatte 4 angeordnet, z.B. je eine Ringdichtung.

Bei der in Fig. 2 gezeigten Leiterplattenanordnung 1 ist das erste 10a Gehäuseelement zur Kapselung direkt an der HDI-Leiterplatte 7 angeordnet, i.e. an der der Standard-Leiterplatte 4 abgewandeten großflächigen Leiterplattenseite 7b der HDI-Leiterplatte 7, während das zweite Gehäuseelement 10b wie bei der Variante von Fig. 1 an der der HDI-Leiterplatte 7 abgewandten Seite 4a der Standard-Leiterplatte 4 angeordnet ist. Hierdurch sind wiederum die Bauelemente 6 an der HDI-Leiterplatte 7 mitsamt der Aussparung 5 gekapselt, die Leiterplattenanordnung 1 samt Gehäuse 10 jedoch noch platzsparender ausgebildet. Zur Abdichtung ist z.B. jeweils eine Dichtung 11 zwischen je einem Gehäuseelement 10a, 10b und der dazu benachbarten Leiterplatte 4 bzw. 7 angeordnet, z.B. eine Ringdichtung, sowie zwischen der HDI-Leiterplatte 7 und der Standard-Leiterplatte 4.

Fig. 3 zeigt eine erfindungsgemäße Leiterplattenanordnung 1, wobei die HDI-Leiterplatte 7 mit der Standard-Leiterplatte 4 lediglich elektrisch verbunden ist, i.e. dauerhaft. Vorgesehen ist die elektrische Verbindung hierbei insbesondere via bloßem Zusammenpressen freiliegender Kontaktelemente 8,9, welche insbesondere als korrespondierende Kontaktflächen an der HDI-Leiterplatte 7 und der Standard-Leiterplatte 4 gebildet sind. Hierbei ist eine mechanische Verbindung der Kontaktelemente 8, 9 untereinander als auch der HDI-Leiterplatte 7 und der Standard-Leiterplatte 4 untereinander nicht vorgesehen. Die HDI-Leiterplatte 7 wird durch ein entsprechend ausgebildetes erstes Gehäuseelement 10a insbesondere dauerhaft und positionstreu gegen die Standard-Leiterplatte 4 gedrängt bzw. mit einer Andruckkraft beaufschlagt, s. Pfeile A in Fig. 3.

Hierzu weist das erste Gehäuseelement 10a vorzugsweise geeignete Eingriffselemente 12 an seiner Innenseite auf, z.B. in Form von Vorsprüngen, welche gegen die HDI-Leiterplatte 7 wirken und diese zur elektrischen Verbindung gegen die Kontaktelemente 9 der Standard-Leiterplatte 4 zwingen. Das erste Gehäuseelement 10a ist hierbei mechanisch mit der Standard-Leiterplatte 4 verbunden, z.B. unter Verwendung einer Dichtung 11 abgedichtet. Zur vollständigen Kapselung ist wiederum ein zweites Gehäuseelement 10b vorgesehen.

Im Rahmen der vorliegenden Erfindung ist vorgesehen, das Gehäuse 10, insbesondere das zweite Gehäuseelement 10b vorteilhaft zur Entwärmung eines in die Aussparung 5 eingetauchten elektronischen Bauelements 6 der HDI-Leiterplatte 7 zu nutzen. Hierzu ist das Bauelement 7 thermisch leitfähig an das Gehäuse 10 bzw. das Gehäuseelement 10b angebunden, z.B. mittels Wärmeleitpaste, einem Wärmeleitelement, Wärmeleitkleber, etc.

Ein mittels einer Leiterplattenanordnung 1 wie vorstehend beschrieben gebildetes Steuergerät 2, insbesondere für ein Kraftfahrzeug, zeichnet sich vorteilhaft durch geringe Materialkosten, eine kleine Baugröße, hohe Toleranzausgleichsmöglichkeit und eine einfache Leiterplattenfertigung im Nutzen aus. Bei einem erfindungsgemäßen Steuergerät 2 ist mittels der Standard-Leiterplatte 4 eine Peripheriekomponente des Steuergeräts 2 mit der Steuerelektronik 3 des Steuergeräts 2 vernetzt, z.B. mehrere oder sämtliche Peripheriekomponenten. Die Steuerelektronik 3 ist hierbei insbesondere an der HDI-Leiterplatte 7 hochintegriert gebildet.

### Bezugszeichen

- 1: Leiterplattenanordnung
- 2: Steuergerät
- 3: Steuerschaltung
- 4: Standard-Leiterplatte
- 4a: Leiterplattenseite
- 4b: Leiterplattenseite
- 4c: Oberflächenbereich benachbart zur Aussparung 5
- 5: Aussparung
- 6: elektronisches Bauelement
- 7: HDI-Leiterplatte
- 7a: Randbereich
- 7b: Leiterplattenseite
- 8, 9: Kontaktelement
- 10: Gehäuse
- 10a: erstes Gehäuseelement
- 10b: zweites Gehäuseelement
- 11: Dichtung
- 12: Eingriffselement
- A: Pfeil

## Patentansprüche

1. Leiterplattenanordnung (1) für ein Steuergerät (2) eines Kraftfahrzeugs, wobei die Leiterplattenanordnung (1) eine insbesondere flexible Standard-Leiterplatte (4), insbesondere eine FR4-Leiterplatte, aufweist, wobei in der Standard-Leiterplatte (4) eine Aussparung (5) gebildet ist, insbesondere in Form einer Durchgangsöffnung, und wobei die Leiterplattenanordnung (1) weiterhin eine HDI-Leiterplatte (7) aufweist, welche an der Standard-Leiterplatte (4) die Aussparung (5) überlappend angeordnet ist, und ein Gehäuse (10) mit einem ersten Gehäuseelement (10a) und einem zweiten Gehäuseelement (10b) vorhanden ist zur Kapselung der Aussparung (5) und der elektronischen Bauelemente (6), **dadurch gekennzeichnet, dass** ein an der HDI-Leiterplatte (7) aufgenommenes elektronisches Bauelement (6) in die Aussparung (5) eintaucht, wobei die HDI-Leiterplatte (7) mittels eines Abschnitts des ersten Gehäuseteils (10a) dauerhaft gegen die Standard-Leiterplatte (4) gedrängt ist und wobei das in die Aussparung (5) eingetauchte elektronische Bauelement (6) mit dem zweiten Gehäuseelement (10b) thermisch leitfähig verbunden ist.

2. Leiterplattenanordnung (1) nach Anspruch 1, **dadurch gekennzeichnet, dass** die Standard-Leiterplatte (4) mittels eines steifen Trägermaterials gebildet ist, insbesondere mittels eines epoxidharzbasierten Trägermaterials, und weiterhin insbesondere flexibel.

3. Leiterplattenanordnung (1) nach einem der vorhergehenden Ansprüche, **dadurch gekennzeichnet, dass** die HDI-Leiterplatte (7) die Aussparung (5) vollständig überlappt, insbesondere deckelt.

4. Leiterplattenanordnung (1) nach einem der vorhergehenden Ansprüche, **dadurch gekennzeichnet, dass** die HDI-Leiterplatte (7) an einem Randbereich (7a) derselben an die Standard-Leiterplatte (4) ankontaktiert ist, insbesondere einen Oberflächenbereich (4c) der Standard-Leiterplatte (4) benachbart zur Aussparung (5) kontaktierend.

5. Leiterplattenanordnung (1) nach einem der vorhergehenden Ansprüche, **dadurch gekennzeichnet, dass** die HDI-Leiterplatte (7) mittels der mechanischen Verbindung elektrisch an der Standard-Leiterplatte (4) ankontaktiert ist, insbesondere mittels eines Klebstoffs.

6. Leiterplattenanordnung (1) nach einem der vorhergehenden Ansprüche 1 bis 4, **dadurch gekennzeichnet, dass** die HDI-Leiterplatte (7) und die Standard-Leiterplatte (4) untereinander mechanisch unverbunden sind.

7. Leiterplattenanordnung (1) nach einem der vorhergehenden Ansprüche, **dadurch gekennzeichnet, dass** die HDI-Leiterplatte (7) beidseitig bestückt ist.

8. Steuergerät (2), insbesondere für ein Kraftfahrzeug, **gekennzeichnet durch** eine Leiterplattenanordnung (1) nach einem der vorhergehenden Ansprüche.

9. Steuergerät (2) nach Anspruch 8, **dadurch gekennzeichnet, dass** mittels der Standard-Leiterplatte (4) eine Peripheriekomponente mit einer Steuerelektronik (3) des Steuergeräts (2) vernetzt ist.

10. Steuergerät (2) nach Anspruch 8 oder 9, **dadurch gekennzeichnet, dass** die Steuerelektronik (3) des Steuergeräts (2) an der HDI-Leiterplatte (7) gebildet ist.

## Claims

1. Printed circuit board arrangement (1) for a control device (2) of a motor vehicle, wherein the printed circuit board arrangement (1) has an, in particular flexible, standard printed circuit board (4), in particular an FR4 printed circuit board, wherein a cutout (5) is formed in the standard printed circuit board (4), in particular in the form of a passage opening, and wherein the printed circuit board arrangement (1) also has an HDI printed circuit board (7) which is arranged on the standard printed circuit board (4) so as to overlap the cutout (5), and there is a housing (10) with a first housing element (10a) and a second housing element (10b) for the purpose of encapsulating the cutout (5) and the electronic components (6), **characterized in that** an electronic component (6) which is accommodated on the HDI printed circuit board (7) enters the cutout (5), wherein the HDI printed circuit board (7) is permanently pushed against the standard printed circuit board (4) by means of a section of the first housing part (10a), and wherein the electronic component (6) which enters the cutout (5) is thermally conductively connected to the second housing element (10b).

2. Printed circuit board arrangement (1) according to Claim 1, **characterized in that** the standard printed circuit board (4) is formed by means of a rigid carrier material, in particular by means of an epoxy resin-based carrier material, and also is flexible in particular.

3. Printed circuit board arrangement (1) according to either of the preceding claims, **characterized in that** the HDI printed circuit board (7) fully overlaps, in particular covers, the cutout (5).

4. Printed circuit board arrangement (1) according to one of the preceding claims, **characterized in that** the HDI printed circuit board (7), at an edge region (7a) thereof, makes contact with the standard printed circuit board (4), in particular so as to make contact with a surface region (4c) of the standard printed circuit board (4) adjacent to the cutout (5).

5. Printed circuit board arrangement (1) according to one of the preceding claims, **characterized in that** the HDI printed circuit board (7) is electrically contact-connected to the standard printed circuit board (4) by means of the mechanical connection, in particular by means of an adhesive.

6. Printed circuit board arrangement (1) according to one of the preceding Claims 1 to 4, **characterized in that** the HDI printed circuit board (7) and the standard printed circuit board (4) are not mechanically connected to one another.

7. Printed circuit board arrangement (1) according to one of the preceding claims, **characterized in that** the HDI printed circuit board (7) is populated on both sides.

8. Control device (2), in particular for a motor vehicle, **characterized by** a printed circuit board arrangement (1) according to one of the preceding claims.

9. Control device (2) according to Claim 8, **characterized in that** a peripheral component is networked with a control electronics system (3) of the control device (2) by means of the standard printed circuit board (4).

10. Control device (2) according to Claim 8 or 9, **characterized in that** the control electronics system (3) of the control device (2) is formed on the HDI printed circuit board (7).

## Revendications

1. Système de carte de circuit imprimé (1) pour un appareil de commande (2) d'un véhicule automobile, dans lequel le système de carte de circuit imprimé (1) comporte une carte de circuit imprimé standard (4) notamment flexible, notamment une carte de circuit imprimé FR4, dans lequel un évidement (5) est formé dans la carte de circuit imprimé standard (4), notamment sous forme d'une ouverture de passage, et dans lequel le système de carte de circuit imprimé (1) comporte en outre une carte de circuit imprimé HDI (7) disposée sur la carte de circuit imprimé standard (4) de manière à recouvrir l'évidement (5), et un boîtier (10) comportant un premier élément de boîtier (10a) et un deuxième élément de boîtier (10b) qui est prévu pour encapsuler l'évidement (5) et les composants électroniques (6), **caractérisé en ce qu'**un composant électronique (6) monté sur la carte de circuit imprimé HDI (7) pénètre dans l'évidement (5), dans lequel la carte de circuit imprimé HDI (7) est repoussée en permanence contre la carte de circuit imprimé standard (4) au moyen d'une section de la première partie de boîtier (10a) et dans lequel le composant électronique (6) pénétrant dans l'évidement (5) est relié de manière thermiquement conductrice au deuxième élément de boîtier (10b).

2. Système de carte de circuit imprimé (1) selon la revendication 1, **caractérisé en ce que** la carte de circuit imprimé standard (4) est réalisée au moyen d'un matériau de support rigide, notamment au moyen d'un matériau de support à base de résine époxyde, qui est notamment en outre flexible.

3. Système de carte de circuit imprimé (1) selon l'une quelconque des revendications précédentes, **caractérisé en ce que** la carte de circuit imprimé HDI (7) recouvre entièrement l'évidement (5), en formant notamment un couvercle.

4. Système de carte de circuit imprimé (1) selon l'une quelconque des revendications précédentes, **caractérisé en ce que** la carte de circuit imprimé HDI (7) est mise en contact au niveau d'une région de bord (7a) de celle-ci avec la carte de circuit imprimé standard (4), et est notamment en contact avec l'évidement (5) en étant adjacente à une région de surface (4c) de la carte de circuit imprimé standard (4).

5. Système de carte de circuit imprimé (1) selon l'une quelconque des revendications précédentes, **caractérisé en ce que** la carte de circuit imprimé HDI (7) est mise en contact électrique avec la carte de circuit imprimé standard (4) au moyen d'une liaison mécanique, en particulier au moyen d'un adhésif.

6. Système de carte de circuit imprimé (1) selon l'une quelconque des revendications 1 à 4 précédentes, **caractérisé en ce que** la carte de circuit imprimé HDI (7) et la carte de circuit imprimé standard (4) ne sont pas reliées mécaniquement l'une à l'autre.

7. Système de carte de circuit imprimé (1) selon l'une quelconque des revendications précédentes, **caractérisé en ce que** la carte de circuit imprimé HDI (7) est équipée de composants sur les deux faces.

8. Appareil de commande (2), notamment destiné à un véhicule automobile, **caractérisé par** un système de carte de circuit imprimé (1) selon l'une quelconque des revendications précédentes.

9. Appareil de commande (2) selon la revendication 8, **caractérisé en ce qu'**un composant périphérique est interconnecté à une électronique de commande (3) de l'appareil de commande (2) au moyen de la carte de circuit imprimé standard (4).

10. Appareil de commande (2) selon la revendication 8 ou 9, **caractérisé en ce que** l'électronique de commande (3) de l'appareil de commande (2) est formée sur la carte de circuit imprimé HDI (7).
